# EUROPEAN PATENT APPLICATION

(11) **EP 1 408 504 A1**
(43) Date of publication of application: **14.04.2004**
(21) Application number: 02733490.3
(22) Date of filing: 12.06.2002
(51) Int. Cl.: G11B 20/14, G11B 20/10, H04L 9/00

(54) **RECORDING MEDIUM RECORDING APPARATUS, RECORDING METHOD, RECORDING MEDIUM REPRODUCTION APPARATUS, AND REPRODUCTION METHOD**

(30) Priority: 12.06.2001 JP 2001177571
(71) Applicant: Sony Corporation, Tokyo 141-0001 (JP)
(72) Inventor: SAKO, Yoichiro c/o SONY CORPORATION, Shinagawa-ku, Tokyo 141-0001 (JP)
(74) Representative: Ayers, Martyn Lewis Stanley
(86) International application number: PCT/JP2002/005856
(87) International publication number: WO 2002/101743

(57) **Abstract**

The present invention is directed to a recording method of modulating data to record this modulated data with respect to a recording medium, wherein in recording data with respect to the recording medium, there is employed an approach to switch a way of selection of plural conversion tables stored in a memory unit where the plural conversion tables for converting data of m bits into n (m < n) bits on the basis of kind of data recorded with respect to the recording medium to modulate inputted data of m bits into data of n bits by using selected conversion table to record the modulated data with respect to the recording medium.

## Description

### Technical Field

The present invention relates to a recording apparatus and a recording method for recording modulated data with respect to a recording medium, and relates to a reproducing apparatus and a reproducing method for demodulating data from a recording medium where modulated data is recorded to reproduce it.

### Background Art

Onto a Digital Versatile Disc (hereinafter simply referred to as DVD as occasion may demand), for the purpose of protection of copyright of data to be recorded, data is recorded after scramble operation has been implemented on the basis of access limitation system such as CSS (Content Scramble System), etc. Such DVD is adapted to have ability to carry out reproduction of data recorded on the DVD by reproduction only equipment, and to have ability to reproduce data recorded on the DVD also by general equipment such as personal computer, etc. Such reproduction only equipment and/or general equipment releases scramble of data recorded on DVD by using cryptanalytic key stored in the memory within the equipment, thereby making it possible to reproduce data recorded on the DVD.

Meanwhile, there is carried out a method of copying data recorded on DVD onto hard disc of personal computer, etc. as it is to unfairly release scramble of data by using software. In order to prevent such a deed, it is required that data for releasing scramble of data is not copied as it is with respect to personal computer, etc.

### Disclosure of the Invention

An object of the present invention is to provide a recording apparatus and a recording method for recording medium for recording data with respect to data recording medium secret data in such a manner that secret data such as data for releasing or decoding cryptogram is not copied as it is with respect to personal computer, etc. to have ability to prevent unfair copy of digital data, a reproducing apparatus and a reproducing method for recording medium which reproduce a recording medium where data is recorded by such recording apparatus and recording method, and a data outputting method and a data decoding method.

A recording apparatus for a recording medium according to the present invention which is proposed in order to attain the object as described above comprises a memory unit in which plural conversion tables for converting data of m bits into data ofn (m < n) bits are stored, a select control unit for switching a way of selection of plural conversion tables stored in the memory unit in dependency upon kind of data of in bits recorded with respect to the recording medium, a modulation processing unit for modulating inputted data of m bits into data of n bits by using the conversion table selected by the select control unit, and a recording unit for recording output data from the modulation processing unit with respect to the recording medium.

The recording apparatus for recording medium further comprises an encipherment circuit unit for implementing encipherment processing to data of m bits on the basis of random number data, and the select control unit selects plural conversion tables stored in the memory unit on the basis of random number data.

A recording method for a recording medium according to the present invention comprising the steps of: switching, in recording data with respect to the recording medium, a way of selection of plural conversion tables stored in a memory unit in which the plural conversion tables for converting data ofm bits into n (m < n) bits are stored on the basis of kind of data recorded with respect to the recording medium; modulating inputted data of m bits into data of n bits by using selected conversion table; and recording the modulated data with respect to the recording medium.

A reproducing apparatus for a recording medium according to the present invention comprises a head unit for reading out data from the recording medium where data ofn bits is recorded, a memory unit in which plural conversion tables for converting data of m bits into data of n (m < n) bits are stored, a select control unit for switching a way of selection of plural conversion tables stored in the memory unit in dependency upon kind of data of n bits recorded with respect to the recording medium, and a demodulation processing unit for demodulating data of n bits based on an output signal from the head unit into data of m bits by using the conversion table selected by the select control unit.

The reproducing apparatus for recording medium further comprises an extracting unit for extracting data for decoding cryptogram implemented to data of n bits on the basis of collation result by a collation unit, and a cryptanalyzing unit for decoding cryptogram of output data from the demodulation processing unit by using data for decoding cryptogram extracted by the extracting unit.

A reproducing method for a recording medium according to the present invention comprising the steps of: switching a way of selection of plural conversion tables stored in a memory unit in which the plural conversion tables for converting data of n bits into data of m (m < n) bits are stored in dependency upon kind of data of n bits which has been read out from the recording medium; and demodulating the data ofn bits which has been read out into data of m bits by using the selected conversion table.

A data outputting method according to the present invention comprising the steps of: switching, in outputting data, a way of selection of plural conversion tables stored in a memory unit in which the plural conversion tables for converting data of m bits into data of n (m < n) bits are stored on the basis of kind of outputted data; modulating the data of in bits which has been read out into data of n bits by using the selected conversion table; and outputting the modulated data.

A data decoding method according to the present invention comprising the steps of: switching a way of selection of plural conversion tables stored in a memory unit in which the plural conversion tables for converting data of n bits into data of m (m < n) bits are stored in dependency upon kind of delivered data of n bits; and modulating the data of n bits which has been read out into the data of m bits by using the selected conversion table.

Still more further objects of the present invention and more practical merits obtained by the present invention will become more apparent from the description of the embodiments which will be given below with reference to the attached drawings.

### Brief Description of the Drawings

Fig. 1 is view for explaining the configuration of an optical disc to which the present invention is applied.
Fig. 2 is a view for explaining another example of an optical disc according to the present invention.
Fig. 3 is a block diagram showing a recording apparatus to which the present invention is applied.
Fig. 4 is a view for explaining main conversion table for carrying out 8-16 modulation.
Fig. 5 is a view for explaining auxiliary conversion table for carrying out 8-16 modulation.
Fig. 6 is a block diagram for explaining a reproducing apparatus for optical disc.
Fig. 7 is a flowchart for explaining procedure for extracting random number data.
Fig. 8 is a flowchart for explaining procedure for extracting random number data by code number.
Fig. 9 is a flowchart for explaining procedure for extracting random number data by even/odd number of code number.

### Best Mode for Carrying Out the Invention

Explanation will now be given with reference to the attached drawings in connection with a data recording medium, a data recording apparatus and a data recording method to which the present invention is applied.

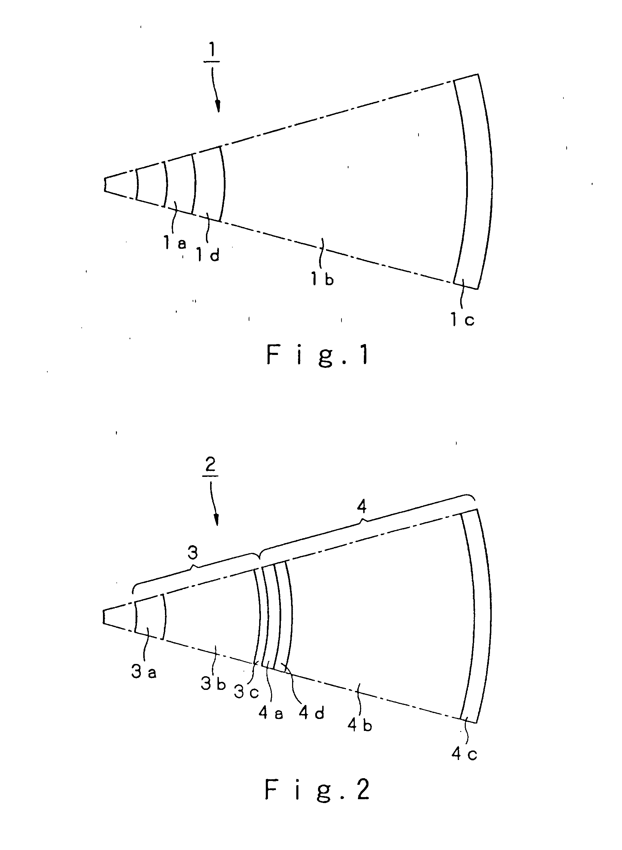

The data recording medium to which the present invention is applied is directed to a recordable optical disc. As shown in Fig. 1, this optical disc 1 is adapted so that a lead-in area 1a where TOC (Table of Contents), etc. is recorded is provided at the inner circumferential side, a program area 1b where contents data is recorded after undergone encipherment is provided at the outer circumferential side of this lead-in area 1a, and a lead-out area 1c is provided at the outer circumferential side of this program area 1b. Between the lead-in area 1a and the program area 1b, a key locker area 1d which stores contents key data for enciphering contents data recorded in the program area 1b is provided. This contents key data is stored in the key locker area 1d after it is enciphered by secret key data, e.g., random number data at the time of recording.

The optical disc to which the present invention is applied may be also constituted as shown in Fig. 2. As shown in Fig. 2, this optical disc 2 is adapted so that a first session 3 is provided at the inner circumferential side, and a second session 4 is provided at the outer circumferential side of the first session 3. The respective sessions 3, 4 are adapted so that lead-in areas 3a, 4a are respectively provided, wherein program areas 3b, 4b where contents data are recorded are provided succeedingly to the lead-in areas 3a, 4a, and lead-out areas 3c, 4c are provided succedingly to the program areas 3b, 4b. Here, the first session 3 is adapted so that, e.g., data is recorded at the same recording density as recording density of the so-called compact disc, and the second session 4 is adapted so that data is recorded at a recording density higher than that of the first session 3. Between the lead-in area 4a and the program area 4b of the second session 4, a key locker area 4d where contents key data for recording contents data into the program area 4b after undergone encipherment is stored is provided. This contents key data is stored in the key locker area after it is enciphered by secret key data, e.g., random number data at the, time of recording.

The optical disc 2 constituted as described above is adapted so that, e.g., contents data is recorded at the second session 4 of the outer circumferential side, and advertisement data, etc. of the contents data recorded at the second session 4 is recorded at the first session 3 of the inner circumferential side. In this optical disc 2, it is sufficient to record higher quality data into the second session 4 as compared to the first session 3.

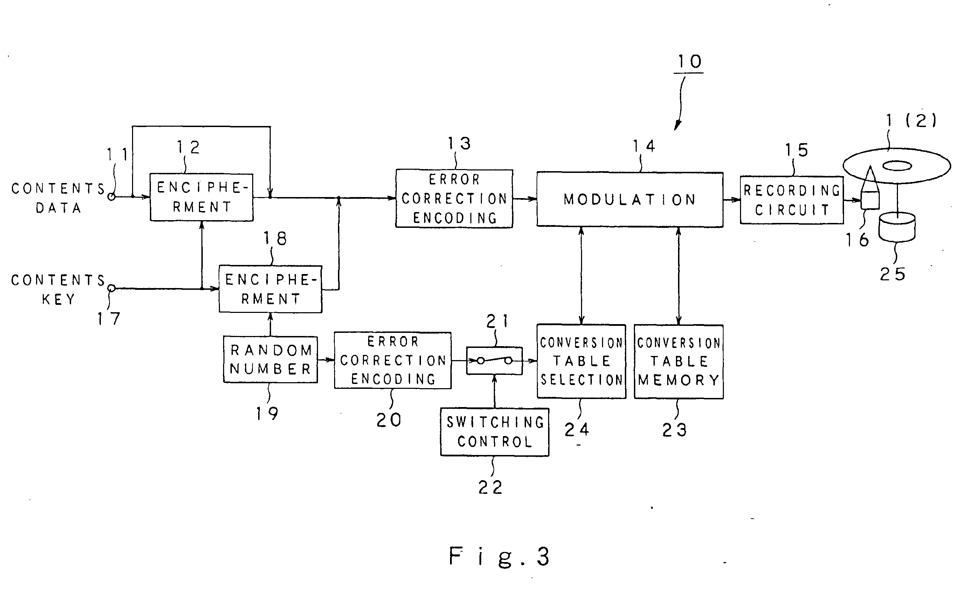

Then, explanation will be given with reference to Fig. 3 in connection with a data, recording apparatus 10 which is a recording apparatus for recording medium to which the present invention is applied. This data recording apparatus 10 comprises an encipherment circuit 12 for enciphering contents data which has been inputted from an input terminal 11, an error correction encoding circuit 13 for implementing error correction encoding processing to the contents data which has been enciphered at the encipherment circuit 12, a modulation circuit 14 for modulating the contents data to which error correction encoding processing has been implemented, a recording processing circuit 15 for implementing recording processing to the contents data which has been caused to undergo modulation processing, an optical pick-up 16 for recording data onto an optical disc 1 or 2, and a spindle motor 25 for rotationally driving the optical disc 1 or 2.

This data recording apparatus 10 comprises an encipherment circuit 18 which enciphers contents key data for enciphering contents data inputted from an input terminal 17, a random number generating circuit 19 which generates random number data for enciphering contents key data at the encipherment circuit 18, an error correction encoding circuit 20 for implementing error correction encoding processing to random number data generated at the random number generating circuit 19, a switch 21 for switching output of the random number data to which error correction encoding processing has been implemented, a switching control unit 22 for switching ON/OFF of the switch 21, a memory 23 in which plural conversion tables for modulating contents data are stored, and a conversion table selecting unit 24 for selecting modulation table on the basis of random number data.

Contents data recorded onto the optical disc 1 or the optical disc 2 is inputted to the encipherment circuit 12 from the input terminal 11. Contents key data for enciphering contents data inputted from the input terminal 17 is inputted to the encipherment circuit 12 which enciphers contents data. The encipherment circuit 12 enciphers inputted contents data by using contents key data to output it to the error correction encoding circuit 13. It is to be noted that contents data recorded at the first session 3 of the optical disc 2 is directly inputted to the error correction encoding circuit 13 without being inputted to the encipherment circuit 12.

The contents key data which has been inputted from the input terminal 17 is inputted to the encipherment circuit 12 which enciphers contents data, and is inputted to the encipherment circuit 18 which inputs contents key data. Random number data serving as secret key data in enciphering contents key data, e.g., data of 8 bits (10100100) is inputted from the random number generating circuit 19. The encipherment circuit 18 enciphers contents key data by random number data thereafter to input the contents key data which has been enciphered by random number data to the error correction encoding circuit 13.

The error correction encoding circuit 13 which is supplied with enciphered or non-enciphered contents data, and is supplied with enciphered contents key data carries out encoding processing which generates error correction code such as CIRC (Cross Interleaved Reed-Solomon Code), etc. to add it to inputted data. Further, the error correction encoding circuit 13 outputs error correction encoding processed data to the modulation circuit 14.

Meanwhile, the above-described random number generating circuit 19 generates random number data in order to encipher contents key data to output this random number data to the encipherment circuit 18 which enciphers contents key data, and to output it to the error correction encoding circuit 20 in order to carry out processing for recording random number data onto the optical disc 1 or the optical disc 2. The error correction encoding circuit 20 which has been supplied with random number data carries out error correction encoding processing with respect to random number data. The error correction encoding circuit 20 outputs random number data to the conversion table selecting unit 24 through the switch 21 in order to record it onto the optical disc 1 or the optical disc 2. The switch 21 is adapted so that ON/OFF is caused to undergo switching control by the switching control unit 22. The switching control unit 22 allows the switch 21 to be turned ON only when enciphered contents key data is recorded with respect to the key locker areas 1d, 4d of the optical disc 1 or the optical disc 2 to output random number data to which error correction encoding processing has been implemented to the cohversion table selecting unit 24.

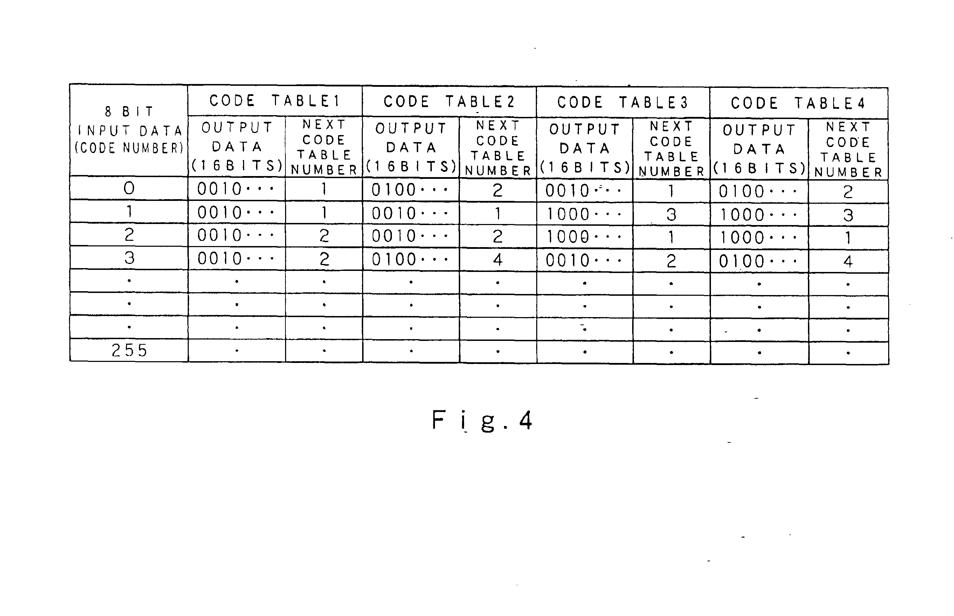

The modulation circuit 14 carries out, e.g., 8-16 modulation processing with respect to inputted data. Plural conversion tables for carrying out 8-16 modulation processing are stored in the memory 23. In more practical sense, the conversion table stored in the memory 23 has, as shown in Fig. 4, four code tables for converting input data of 8 bits into 16 bits. This conversion table is adapted so that code table numbers used next with respect to input data of respective 8 bits are determined.

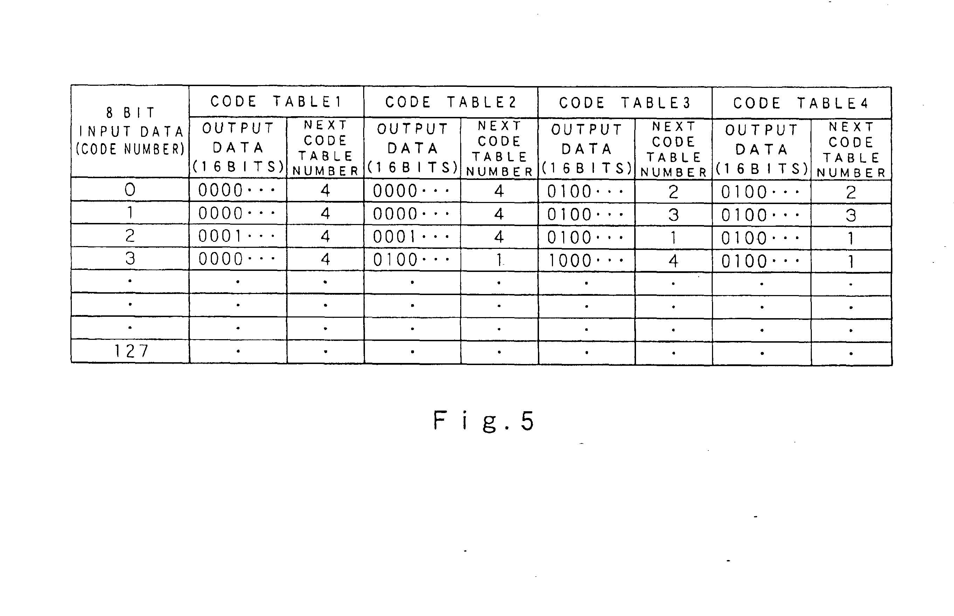

As shown in Fig. 5, auxiliary conversion table of the conversion table shown in Fig. 4 is stored in the memory 23. In the case where, e.g., the conversion table shown in Fig. 4 is used to cany out 8-16 modulation, when d.c. component of signal, i.e., absolute value of DSV (Digital Sum Variation) is a predetermined value or more, this auxiliary conversion table is used for allowing DSV to be less than a predetermined value. This auxiliary conversion table also has four code tables for converting input data of 8 bits into 16 bits, wherein code table numbers used next with respect to input data of respective 8 bits are determined.

The modulation circuit 14 selects code tables 1- 4 in accordance with the rule prescribed in the conversion table by using the conversion table shown in Fig. 4 in ordinary state, i.e., when it modulates contents data. For example, as shown in Fig. 4, the modulation circuit 14 is operative so that when it converts 8 bit data in which input code number is 2 into data of 16 bits by using code table 1, it concerts next data of 8 bits into data of 16 bits by using code table 2. The modulation circuit 14 selects code tables 1-4 in accordance with the rule prescribed in this auxiliary conversion table also when it selects the auxiliary conversion table shown in Fig. 5 for allowing DSV to be less than a predetermined value. The modulation circuit 14 outputs modulated contents data, i.e., data of 16 bits to the recording processing circuit 15.

The modulation circuit 14 operates as follows when it records enciphered contents key data into the key locker areas 1d, 4d of the optical disc 1 or 2. First, enciphered contents key data to which error correction encoding processing has been implemented is inputted from the error correction encoding circuit 13 to the modulation circuit 14. When enciphered contents key data is recorded into the key locker areas 1d, 4d, the switching control unit 22 allows the switch 21 to be turned ON. Thus, random number data to which error correction processing has been implemented is inputted from the error correction encoding circuit 20 to the conversion table selecting unit 24.

The conversion table selecting unit 24 selects the conversion table shown in Fig. 4 and the auxiliary conversion table shown in Fig. 5 by the rule different from the modulation rule prescribed in, e.g., the conversion table shown in Fig. 4 and the auxiliary conversion table shown in Fig. 5 on the basis of inputted random number data. Namely, the conversion table selecting unit 24 selects conversion table so that data by selection itself of the conversion table shown in Fig. 4 and the auxiliary conversion table shown in Fig. 5 is caused to be random number data at the time of demodulation.

The conversion table selecting unit 24 selects, in selection of the conversion table shown in Fig. 4 or the auxiliary conversion table shown in Fig. 5, the conversion table shown in Fig. 4 or the auxiliary conversion table shown in Fig, 5 so that run length becomes equal to (RLL (2, 10)), i.e., the minimum run of "0" is equal to "2" and the maximum run thereof is equal to "10". Further, the conversion table selecting unit 24 selects the conversion table shown in Fig. 4 and the auxiliary conversion table shown in Fig. 5 so that DSV is not equal to a predetermined value or more.

The conversion table selecting unit 24 outputs selected conversion table or auxiliary conversion table and code table number to the modulation circuit 14. The modulation circuit 14 modulates enciphered contents key on the basis of conversion table stored in the memory 23. The modulation circuit 14 outputs, to the conversion table selecting unit 24, kind of conversion table or auxiliary conversion table and code table number used for modulation processing at the present time point so as to have ability to select the conversion table shown in Fig. 4 or the auxiliary conversion table shown in Fig. 5 that the conversion table selecting unit 24 subsequently uses so that run length becomes equal to (RLL (2, 10)) and DSV is not equal to a predetermined value or more. The conversion table selecting unit 24 selects the conversion table shown in Fig. 4 or the auxiliary conversion table shown in Fig. 5 used for the next modulation processing on the basis of random number data as described above. The modulation circuit 14 outputs modulated contents key data to the recording processing circuit 15. The recording processing circuit 15 carries out processing for change to recording data such as binary coding processing, etc. of data of modulated contents data or contents key data to output it to the optical pick-up 16 as storage data.

The optical pick-up 16 irradiates light beams to the signal recording layer of the optical disc 1 or 2 rotated at, e.g., CLV (Constant Linear Velocity) by a spindle motor 25 to record recording data onto the optical disc 1 or 2. In more practical sense, the optical pick-up 16 records, into lead-in area 1a or areas 3a, 4a, TOC (Table of Contents) data, etc. as management data of recording data to be recorded in the program area 1b or areas 3b, 4b, records contents key into the key locker areas 1d, 4d, and records contents data as recording data into the program area 1b or areas 3b, 4b. Particularly, contents data, i.e., recording data is recorded into the program area 4b of the optical disc 2 in the state where recording density thereof is caused to be higher than recording density of the program area 3b.

In the optical discs 1, 2 recorded by the data recording apparatus as described above, when such discs are reproduced by the existing data reproducing apparatus, because contents key data stored in the key locker areas 1d, 4d are modulated by the rule different from the ordinary one, i.e., the rule different from the rule of modulation implemented to contents data serving as recording data, it is impossible to demodulate this contents key data. Accordingly, in the optical discs 1, 2, it is possible to prevent that enciphered contents data is reproduced by a data reproducing apparatus which has not right as in the case of the existing data reproducing apparatus. Namely, as described above, even when data which has been read out from the optical discs 1, 2 on which contents key data is recorded is copied as it is with respect to storage medium such as hard disc, etc. of personal computer, etc. serving as the existing data reproducing apparatus, enciphered contents key data cannot be demodulated, and it is also impossible to extract random number data for enciphering contents key data. From this fact, as described in the prior art, it is possible to prevent that cryptogram of contents key data is unfairly decoded so that cryptogram of contents data recorded on the disc is decoded.

While explanation has been given in the above-described example by taking, as an example, the case where rule of selection of conversion table when modulation processing is implemented to data recorded in the program area 1b or areas 3b, 4b of the optical disc 1, 2 is varied in modulation processing of contents key data, there may be also employed an approach to encipher dummy data on the basis of random number data in place of contents key data to allow the conversion table shown in Fig. 4 or the auxiliary conversion table shown in Fig. 5 to have select switch quantity on the basis of this random number data. In this case, it is sufficient that the conversion table selecting unit 24 carries out conversion into code table number on the basis of random number data to execute modulation processing that the modulation circuit 14 converts dummy data into data of 16 bits on the basis of this code table. It is sufficient that the conversion table selecting unit 24 selects even number and odd number of code table number of the conversion table of Fig. 4 or Fig. 5 on the basis of random number data, and the modulation circuit 14 modulates dummy data by using conversion table of selected code table number of even number or odd number. It is a matter of course that it is sufficient to select the conversion table shown in Fig. 4 and the auxiliary conversion table shown in Fig. 5 on the basis of random number data to allow dummy data to undergo modulation processing on the basis of the selected conversion table. In this case, contents key data is recorded and stored in the key locker areas 1d, 4d, and dummy data is recorded in the key locker areas 1d, 4d; i.e., is recorded in the lead-in area 1a, the program area 1b and the lead-out area 1c of the optical disc 1 and is recorded in the lead-in areas 3a, 4a, the program areas 3b, 4b and the lead-out areas 3c, 4c of the optical disc 2.

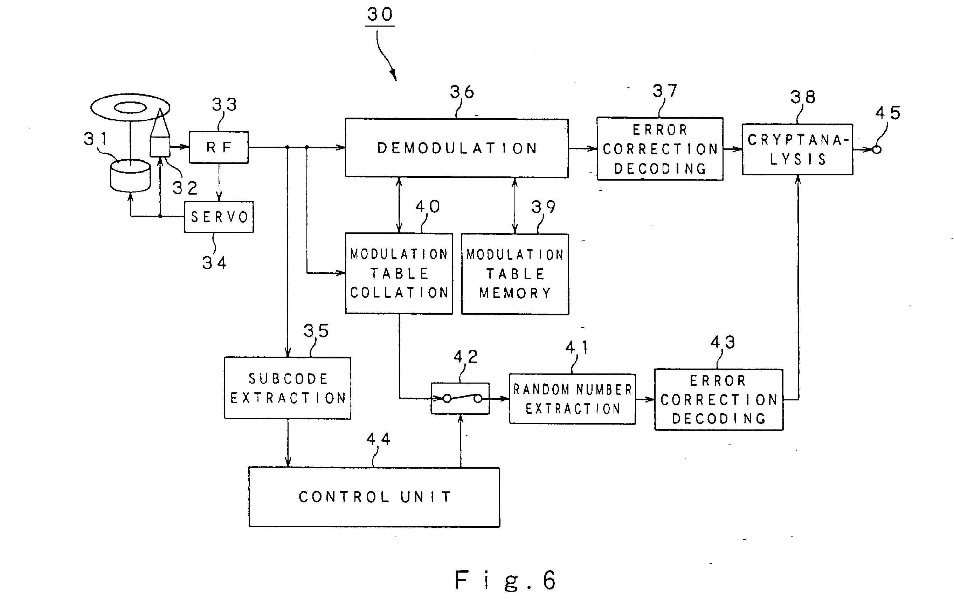

Then, explanation will be given with reference to Fig. 6 in connection with a data reproducing apparatus 30 which reproduces optical discs 1, 2 on which data are recorded by the data recording apparatus 10. This data reproducing apparatus 30 comprises a spindle motor 31 for rotating optical discs 1, 2 at, e.g., CLV (Constant Linear Velocity), an optical pick-up 32 for carrying out read-out of data recorded on the optical discs 1,2, a RF amplifier 33 for amplifying an output signal from the optical pick-up 32, a servo circuit 34 for carrying out servo control of the spindle motor 31 and the optical pick-up 32, a subcode extracting unit 35 for extracting TOC data, etc. from RF signal, a demodulation circuit 36 for implementing demodulation processing to output signal inputted from the RF amplifier 33 to demodulate contents data or contents key data, an error correction decoding circuit 37 for implementing error correction processing to output data from the modulation circuit 36, and a cryptanalyzing circuit 38 for decoding enciphered data outputted from this circuit 37. The data reproducing apparatus 30 comprises a memory 39 in which conversion table used at the time of canying out demodulation processing of data at the demodulation circuit 36 is stored, a collation unit 40 for collating conversion table used for modulation, an extraction unit 41 for extracting random number data for decoding cryptogram of contents key data, a switch 42 for selectively outputting data from the collation unit 40 to the extraction unit 41, an error correction decoding circuit 43 for carrying out error correction processing of random number data extracted at the extraction unit 41, and a control unit 44 for controlling the entire operation of the reproducing apparatus 30 such as switch 42.

The optical pick-up 32 irradiates light beams to the optical disc 1 or 2 rotated at, e.g., CLV (Constant Linear Velocity) by the spindle motor 31 in the state where such light beams are focussed by object lens (not shown) to detect return light beams reflected by the optical disc 1 or 2 by light detector (not shown) to carry out photoelectric conversion thereafter to output corresponding signal to the RF amplifier 33 as an output signal. When the output signal is inputted from the optical pick-up 32, the RF amplifier 33 generates a RF signal as read-out signal of data recorded on the optical disc 1 or 2, and generates a focussing error signal and a tracking error signal from an output signal from the optical pick-up 32. The RF amplifier 33 outputs a RF signal to the demodulation circuit 36 and outputs the focussing error signal and the tracking error signal to the servo circuit 34. The servo circuit 34 generates a focus servo signal and a tracking servo signal on the basis of the focussing error signal and the tracking error signal which have been delivered to output them to the optical pick-up 32. By the focus servo signal and the tracking servo signal, the optical pick-up 32 carries out focussing control and tracking control of object lens by using actuator (not shown). The servo circuit 34 generates a servo signal for the spindle motor 31 on the basis of the RF signal from the RF amplifier 33 to deliver it to this spindle motor 31. As a result, the spindle motor 31 is rotationally controlled so as to rotate the optical disc 1 or 2 at constant linear velocity. The subcode extraction unit 35 extracts subcode data, etc. from the RF signal outputted from the RF amplifier 33 to output TOC data or subcode data, etc. to the control unit 44.

The demodulation circuit 36 implements demodulation processing with respect to 8-16 modulation implemented to data when recorded onto the optical disc 1 or 2. Here, conversion table and auxiliary conversion table which form pair with the conversion table shown in Fig. 4 and the auxiliary conversion table shown in Fig. 5 for carrying out inverse transformation of the conversion table shown in Fig. 4 and the auxiliary conversion table shown in Fig. 5 are stored in the memory 39. The conversion table shown in Fig. 4 and the auxiliary conversion table shown in Fig. 5 serve to convert 8 bits into 16 bits, whereas the conversion table and the auxiliary conversion table which form pair serve to convert data of 16 bits into data of 8 bits.

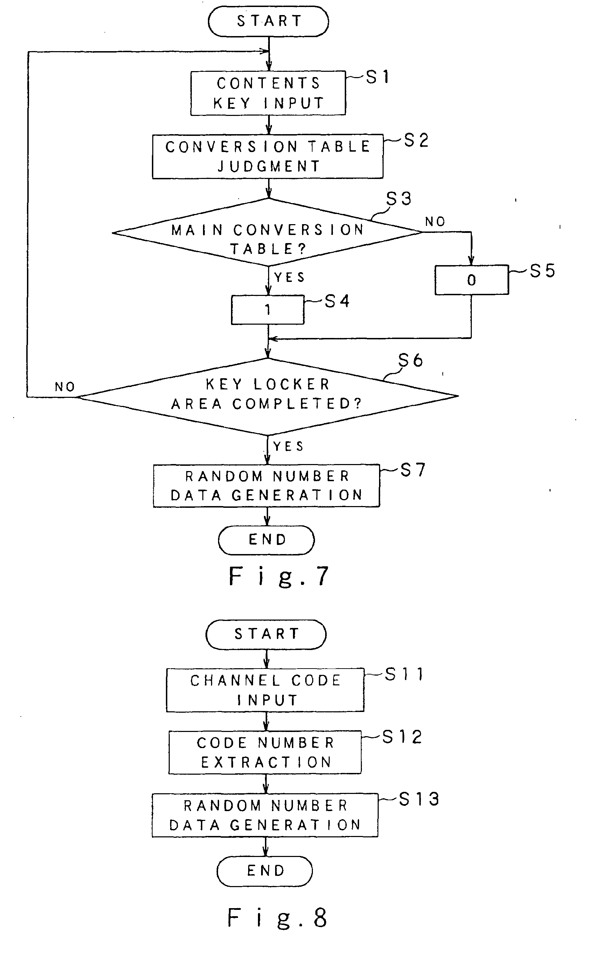

When read-out of the key locker areas 1d, 4d is carried out, the control unit 44 closes the switch 42, i.e., allows it to be turned ON for the purpose of carrying out extraction of random number data used for enciphering contents key data. As shown in Fig. 7, when RF signal is inputted from the RF amplifier 33 at step S1, the collation unit 40 judges at step S2 whether table used in modulating inputted enciphered contents key data is either the conversion table shown in Fig. 4 or the auxiliary conversion table shown in Fig. 5. Here, the collation unit 40 outputs, to the demodulation circuit 36, collation result, i.e., data relating to rule by kind and/or combination of conversion table used in modulation of contents key data, and the demodulation circuit 36 demodulates contents key data on the basis of input from the collation unit 40 and on the basis of either one of conversion table and auxiliary conversion table which form pair with the conversion table shown in Fig. 4 and the auxiliary conversion table shown in Fig. 5 which are stored in the memory 39. In this case, demodulation from contents key data of 16 bits to contents key data of 8 bits is carried out. The demodulation circuit 36 outputs the contents key data thus obtained to the error correction decoding circuit 37.

The collation unit 40 judges at step S3 whether or not inputted enciphered contents key data is modulated by using the conversion table shown in Fig. 4. When the collation unit 40 judges that the conversion table which forms pairs with ,the conversion table shown in Fig. 4 is used, it outputs data of "1" to the extraction unit 41 at step S4, and when the collation unit 40 judges that the conversion table shown in Fig. 4 is not used, it outputs data of "0" to the extraction unit 41 at step S5. When the control unit 44 judges that data read-out of the key locker areas 1d, 4d is completed on the basis of address data inputted from the subcode extraction unit 35, it opens the switch 42, i.e., allows the switch 42 to be turned OFF to complete read-out of contents key data, and when read-out of data is not completed, the control unit 44 repeats processing from the step S1.

The extraction unit 41 which is supplied with "1" or "0" of select data of the conversion table and the auxiliary conversion table used in modulation of contents key data extracts random number data when contents key data is enciphered from inputted data at step S7. The extraction unit 41 outputs random number data to the error correction decoding circuit 43, and the error correction decoding circuit 43 carries out error correction processing of random number data to output the error correction processed random number data to the cryptanalyzing circuit 38.

On the other hand, when demodulated enciphered contents key data is inputted from the demodulation circuit 36, the error correction decoding circuit 37 carries out error correction processing of inputted key data to output it to the cryptanalyzing circuit 38. The cryptanalyzing circuit 38 carries out cryptanalysis of contents key data inputted from the error correction decoding circuit 37 on the basis of random number data inputted from the error correction decoding circuit 43. The cryptanalyzing circuit 38 preserves or stores the cryptanalyzed contents key data into memory (not shown) provided at the reproducing apparatus 30 or memory section, etc. of the control unit 44, etc. so as to have ability to carry out cryptanalysis of enciphered contents data.

Then, when contents data which has been recorded in the program area 1b of the optical disc 1 or the program area 4b of the optical disc 2 after undergone encipherment is read out, the demodulation circuit 36 demodulates enciphered contents data in accordance with the ordinary rule by using the conversion table shown in Fig. 4. The demodulated contents data is caused to undergo error correction processing at the error correction decoding circuit 37, and is then inputted to the cryptanalyzing circuit 38. The cryptanalyzing circuit 38 carries out cryptanalysis processing of contents data by using the cryptanalyzed contents key data. The cryptanalyzing circuit 38 outputs the decoded contents data to an output terminal 45. Monitor and/or speaker are connected to the output terminal 45. When cryptanalyzed contents data is image, it is displayed on the monitor, and when such contents data is audio data, it is outputted from the speaker.

As explained above, the data reproducing apparatus to which the present invention is applied can carry out reproduction of optical discs 1, 2 where data is recorded by the data recording apparatus 10. Namely, the data reproducing apparatus 30 can demodulate contents key data modulated by the rule different from modulation processing implemented to contents data stored in the key locker areas 1d, 4d. Here, since this data reproducing apparatus 30 has the existing conversion table and the auxiliary conversion table shown in Figs. 4 and 5, it is also possible to realize compatibility with the conventional optical disc.

Here, explanation will be given in connection with a demodulation method in the case where dummy data is modulated by using the conversion table shown in Fig. 4 or the auxiliary conversion table shown in Fig. 5 on the basis of random number data in place of contents key data.

First, in the case where code table number is random number data, when the control unit 44 starts read-out of the area where dummy data is recorded of the optical discs 1, 2 as shown in Fig. 8, the control unit 44 allows the switch 42 to be in ON state. Initially, dummy data which has been read out from the optical discs 1, 2 is inputted to the collation unit 40 at step S11. At step S12, the collation unit 40 extracts code table number shown in Fig. 4 or Fig. 5 used in modulating dummy data. At step S13, code table number extracted at the collation unit 40 is inputted to the extraction unit 41. The extraction unit 41 generates random number data necessary for decoding cryptogram of contents key data from code table number. The extraction unit 41 outputs the generated random number data to the cryptanalyzing circuit 38. On the other hand, the demodulation circuit 36 demodulates contents key data stored in the key locker areas 1d, 4d in accordance with the same rule as that in the case where demodulation of contents data is carried out, and the error correction decoding circuit 37 carries out error correction processing of this contents key data. The cryptanalyzing circuit 38 decodes cryptogram implemented to the contents key data on the basis of random number data. The cryptanalyzing circuit 38 is operative so that when enciphered contents data is inputted similarly to the above-described case shown in Fig. 7, it carries out cryptanalysis of contents data by using the cryptanalyzed contents key data to output the content data from the output terminal 45.

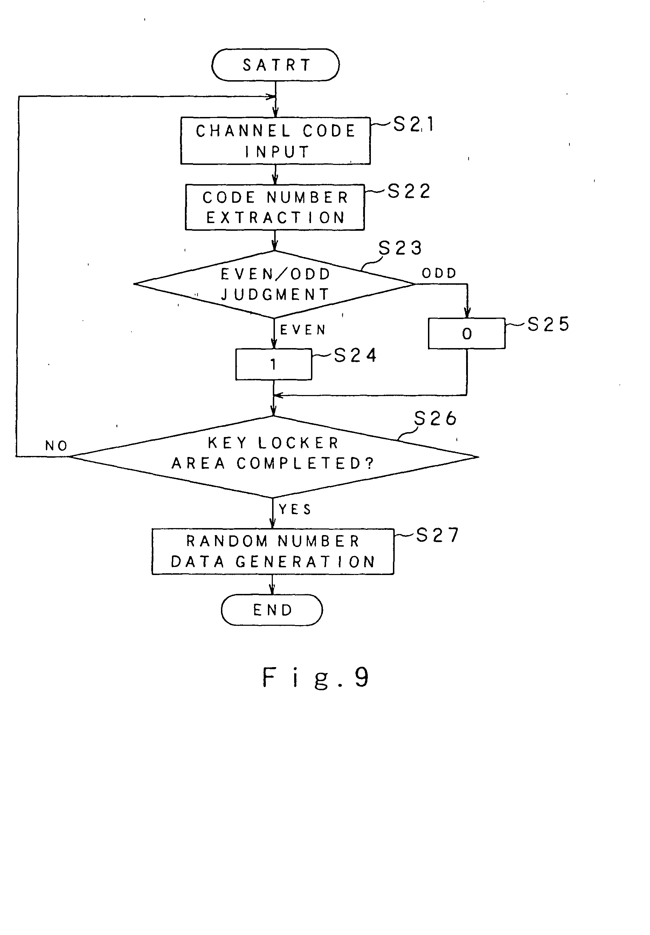

Moreover, in the case where random number data is represented by even number or odd number of code table number, when the control unit 44 starts read-out of the area where dummy data is recorded of the optical discs 1, 2 as shown in Fig. 9, the control unit 44 switches the switch 42 into ON state. First, when RF signal is inputted from the RF amplifier 33 to the collation unit 40 at step S21, the collation unit 40 extracts code table number shown in Fig. 4 or Fig. 5 used in modulating dummy data at step S22. The extraction unit 41 carries out, at step S23, judgment as to whether code table number is even number or odd number. The collation unit 40 is operative so that when code number is even number, it outputs data of "1" to the extraction unit 41 at step S24, while when code table number is odd number, it outputs data of "0" to the extraction unit 41 at step S25. The control unit 44 is operative so that when it is judged on the basis of address data inputted from the subcode extraction unit 35 that read-out of the area where dummy data is recorded of the optical disc 1 or 2 is completed, it switches the switch 42 into OFF state to complete read-out of contents key data, while when read-out of data is not completed, processing from the step S21 is repeated. The extraction unit 41 which has been supplied with data of "1" or "0" on the basis of the result obtained by discriminating whether code table number is even number or odd number extracts random number data when contents key data is enciphered from inputted data at step S27. The extraction unit 41 outputs random number data to the error correction decoding circuit 43, and the error correction decoding circuit 43 carries out error correction processing of inputted random number data to output the error correction processed random number data to the cryptanalyzing circuit 38. On the other hand, the demodulation circuit 36 demodulates contents key data stored in the key locker areas 1d, 4d in accordance with the rule when demodulation processing of contents data is carried out, and the error correction decoding circuit 37 carries out error correction processing of this contents key data. The cryptanalyzing circuit 38 decodes cryptogram of contents key data on the basis of random number data. The cryptanalyzing circuit 38 carries out cryptanalysis of contents data by using the cryptanalyzed contents key data when enciphered contents data is inputted to output contents data from the output terminal 45.

While explanation has been given by taking recordable optical disc as an example, the present invention may be also applied to reproduction only optical disc. In the present invention, rule of modulation processing may be varied in dependency upon kind of optical disc, i.e., reproduction only optical disc, write-once optical disc or rewrite optical disc. While explanation has been given by taking 8-16 modulation system as modulation system in the above-mentioned example, 8-10 modulation system, etc. may be employed in addition to the above. While explanation has been given in the above-mentioned example on the premise that contents key data which enciphers contents data is caused to be main data, and random number data which enciphers this contents key data is caused to be additional data, there may be employed, e.g., an approach in which main data is caused to be contents data, and additional data is caused to be contents key data which enciphers contents data.

The present invention can be also applied to a transmitting apparatus which transmits data recorded by the above-described data recording apparatus to a data receiving apparatus. The present invention can be also applied to a data receiving apparatus which receives and demodulates, data transmitted from this data transmitting apparatus.

### Industrial Applicability

The present invention selects conversion table on the basis of additional data to cany out modulation of main data. When reproduction is carried out, conversion table used for modulation of main data is extracted as data to generate additional data of main data from this data. Accordingly, the existing apparatus is permitted to carry out reproduction of main data, but is not permitted to carry out reproduction of additional data. For example, when main data is caused to be contents data, and this contents data is enciphered by cipher key data serving as additional data, it becomes impossible to acquire this cipher key data with the existing apparatus, and it becomes impossible to reproduce such cipher key data with the existing apparatus. Namely, only by regular apparatus, it becomes possible to decode cryptogram of contents data to reproduce such contents data.

## Claims

1. A recording apparatus for a recording medium comprising:
a memory unit in which plural conversion tables for converting data of m bits into data of n (m < n) bits are stored;
a select control unit for switching a way of selection of plural conversion tables stored in the memory unit in dependency upon kind of data of m bits recorded with respect to the recording medium;
a modulation processing unit for modulating inputted data of m bits into data of n bits by using the conversion table selected by the select control unit; and
a recording unit for recording output data from the modulation processing unit with respect to the recording medium.

2. The recording apparatus for recording medium as set forth in claim 1, wherein the select control unit selects plural conversion tables stored in the memory unit on the basis of data used in enciphering the data of m bits.

3. The recording apparatus for recording medium as set forth in claim 2, wherein the apparatus further comprises an encipherment circuit unit for implementing encipherment processing to the data of m bits on the basis of random number data, and the select control unit selects plural conversion tables stored in the memory unit on the basis of the random number data.

4. The recording apparatus for recording medium as set forth in claim 1, wherein the select control unit switches a way of selection of plural conversion tables stored in the memory unit in dependency upon the case where enciphered contents data of m bits is recorded with respect to the recording medium, and the case where key data of m bits used when the encipherment is carried out is recorded with respect to the recording medium.

5. The recording apparatus for recording medium as set forth in claim 4, wherein the select control unit is operative so that when the enciphered contents data is recorded with respect to the recording medium, it selects plural conversion tables stored in the memory unit in accordance with a predetermined rule so that d.c. component of signal becomes smaller than a predetermined value, and when the key data is recorded with respect to the recording medium, it selects plunal conversion tables stored in the memory unit in accordance with a rule different from the predetermined rule.

6. The recording apparatus for recording medium as set forth in claim 5, wherein the apparatus further comprises an encipherment circuit unit for implementing encipherment processing to the key data of m bits on the basis of random number data, and the select control unit selects plural conversion tables stored in the memory unit on the basis of the random number data.

7. The recording apparatus for recording medium as set forth in claim 1, wherein the modulation processing unit carries out modulation processing on the basis of 8-16 modulation system where m is 8 and n is 16.

8. A recording method for a recording medium comprising the steps of:
switching, in recording data with respect to the recording medium, a way of selection of plural conversion tables stored in a memory unit where there are stored the plural conversion tables for converting data of m bits into n (m< n) bits on the basis of kind of data to be recorded with respect to the recording medium;
modulating inputted data of m bits into data of n bits by using the selected conversion table; and
recording the modulated data with respect to the recording medium.

9. The recording method for recording medium as set forth in claim 8, wherein the method comprises the step of selecting plural conversion tables stored in the memory unit on the basis of data used in enciphering the data of m bits.

10. The recording method for recording medium as set forth in claim 9, wherein the method further comprises the step of carrying out encipherment into the data ofm bits on the basis of random number data to select plural conversion tables stored in the memory unit on the basis of the random number data.

11. The recording method for recording medium as set forth in claim 8, wherein the method comprises the step of switching a way of selection of plural conversion tables stables stored in the memory unit in dependency upon the case where enciphered contents data of m bits is recorded with respect to the recording medium and the case where key data of m bits used when the encipherment is carried out is recorded with respect to the recording medium.

12. The recording method for recording medium as set forth in claim 11, wherein the method comprises the steps of selecting plural conversion tables stored in the memory unit in accordance with a predetermined rule so that d.c. component of signal becomes smaller than a predetermined value when the enciphered contents data is recorded with respect to the recording medium; and selecting plural conversion tables stored in the memory unit in accordance with a rule different from the predetermined rule when the key data is recorded with respect to the recording medium.

13. The recording method for recording medium as set forth in claim 12, wherein the method further comprises the step of carrying out encipherment into the key data of m bits on the basis of random number data; and selecting plural conversion tables stored in the memory unit on the basis of the random number data.

14. The recording method for recording medium as set forth in claim 8, wherein, at modulation processing in the method, modulation processing is carried out on the basis of 8-16 modulation system where m is 8 and n is 16.

15. A reproducing apparatus for a recording medium comprising:
a head unit for reading out data from the recording medium where data of n bits is recorded;
a memory unit in which plural conversion tables for converting data of m bits into data of n (m < n) bits are stored;
a select control unit for switching a way of selection of plural conversion tables stored in the memory unit in dependency upon kind of data of n bits to be recorded with respect to the recording medium; and
a demodulation processing unit for demodulating data ofn bits based on an output signal from the head unit into data of m bits by using conversion table selected by the select control unit.

16. The reproducing apparatus for recording medium as set forth in claim 15, wherein the select control unit comprises a collation unit for discriminating kind of conversion table for modulation used in modulation processing of data of n bits based on an output signal from the head unit, and the select control unit delivers a select control signal for selecting the conversion table to the demodulation processing unit on the basis of discrimination result by the collation unit.

17. The reproducing apparatus for recording medium as set forth in claim 16, wherein the apparatus further comprises an extraction unit which extracts data for decoding cryptogram implemented to the data of n bits on the basis of collation result by the collation unit, and a cryptanalyzing unit for decoding cryptogram of output data from the demodulation processing unit by using data for decoding cryptogram extracted by the extraction unit.

18. The reproducing apparatus for recording medium as set forth in claim 16, wherein enciphered contents data of n bits and enciphered key data of n bits for decoding cryptogram of the contents data are recorded with respect to the recording medium, and the select control unit is operative so that when contents data of n bits is read out from the recording medium, it selects either one of plural conversion tables stored in the memory unit in accordance with a predetermined rule, and when the key data is read out from the recording medium, it selects the conversion table on the basis of discrimination result by the collation unit.

19. The reproducing apparatus for recording medium as set forth in claim 16, wherein the apparatus first reads out the enciphered key data recorded with respect to the recording medium, and the select control unit delivers a select control signal for selecting the conversion table to the demodulation processing unit on the basis of discrimination result by the collation unit to demodulate the enciphered key data.

20. The reproducing apparatus for recording medium as set forth in claim 19, wherein the apparatus further extracts data for decoding cryptogram of the enciphered key data on the basis of collation result by the collation unit to decode cryptogram of enciphered key data outputted from the demodulation processing unit by using the extracted data for decoding cryptogram.

21. The reproducing apparatus for recording medium as set forth in claim 20, wherein the apparatus decodes cryptogram of enciphered contents data outputted from the demodulation processing unit by using the decoded key data.

22. The reproducing apparatus for recording medium as set forth in claim 20, wherein the demodulation processing unit carries out demodulation processing on the basis of 8-16 modulation system where m is 8 and n is 16.

23. A reproducing method for a recording medium comprising the steps of:
switching a way of selection of plural conversion tables stored in a memory unit in which there are stored the plural conversion tables for converting data of n bits into data of m (m < n) bits in dependency upon data of n bits which has been read out from the recording medium; and
demodulating the data of n bits which has been read out into data of m bits by using the selected conversion table.

24. The reproducing method for recording medium as set forth in claim 23, wherein the method comprises the steps of carrying out discrimination collation of kind of conversion table for modulation used in modulation processing of the data ofn bits which has been read out from the recording medium; and selecting plural conversion tables stored in the memory unit on the basis of the collation result.

25. The reproducing method for recording medium as set forth in claim 24, wherein the method further comprises the steps of extracting data for decoding cryptogram implemented to the data of n bits on the basis of the collation result; and decoding cryptogram of the demodulated data by using the extracted data for decoding cryptogram.

26. The reproducing method for recording medium as set forth in claim 24, wherein enciphered contents data of n bits and enciphered key data of n bits for decoding cryptogram of the contents data are recorded with respect to the recording medium, and the method comprises the steps of: selecting either one of plural conversion tables stored in the memory unit in accordance with a predetermined rule when contents data of n bits is read out from the recording medium; and selecting the conversion table on the basis of the collation result when the key data is read out from the recording medium.

27. The reproducing method for recording medium as set forth in claim 24, wherein the method comprises the steps of first reading out the enciphered key data recorded with respect to the recording medium; delivering a select control signal for selecting the conversion table on the basis of the collation result; and demodulating the enciphered key data.

28. The reproducing method for recording medium as set forth in claim 27, wherein the method further comprises the steps of extracting data for decoding cryptogram of the enciphered key data on the basis of the collation result; and decoding cryptogram of the demodulated enciphered key data by using the extracted data for decoding cryptogram.

29. The reproducing method for recording medium as set forth in claim 28, wherein the method comprises the steps of decoding cryptogram of the demodulated enciphered contents data by using the decoded key data.

30. The reproducing method for recording medium as set forth in claim 23, wherein, at demodulation processing in the method, demodulation processing is carried out on the basis of 8-16 modulation system where m is 8 and n is 16.

31. A data outputting method comprising the steps of:
switching, in outputting data, a way of selection of plural conversion tables stored in a memory unit where there are stored the plural conversion tables for converting data of m bits into data ofn (m < n) bits on the basis of kind of the outputted data;
modulating the data of m bits which has been read out into data of n bits by using the selected conversion table; and
outputting the modulated data.

32. The data outputting method as set forth in claim 31, wherein the method comprises the step of selecting plural conversion tables stored in the memory unit on the basis of data used in enciphering the data of m bits.

33. The data outputting method as set forth in claim 32, wherein the method further comprises the steps of enciphering the data ofm bits on the basis of random number data; and selecting plural conversion tables stored in the memory unit on the basis of the random number data.

34. The data outputting method as set forth in claim 31, wherein the method comprises: switching a way of selection of plural conversion tables stored in the memory unit in dependency upon the case where the enciphered contents data of m bits is outputted and the case where key data of m bits used in enciphering the contents data is outputted.

35. The data outputting method as set forth in claim 34, wherein the method comprises the steps of selecting plural conversion tables stored in the memory unit in accordance with a predetermined rule so that d.c. component of signal becomes smaller than a predetermined value when the enciphered contents data is outputted; and selecting plural conversion tables stored in the memory unit in accordance with a rule different from the predetermined rule when the key data is outputted.

36. The data outputting method as set forth in claim 35, wherein the method further comprises the steps of carrying out encipherment into the key data of m bits on the basis of random number data; and selecting plural conversion tables stored in,the memory unit on the basis of the random number data.

37. The data outputting method as set forth in claim 31, wherein modulation processing in the method is carried out on the basis of 8-16 modulation system where m is 8 and n is 16.

38. A data decoding method comprising the steps of:
switching a way of selection of plural conversion tables stored in a memory unit where the plural conversion tables for converting data ofn bits into data of m (m < n) bits in dependency upon kind of delivered data of n bits; and
demodulating the data of n bits which has been read out into data of m bits by using the selected conversion table.

39. The data decoding method as set forth in claim 38, wherein the method comprises the steps of carrying out discrimination collation of kind of conversion table for modulation used in modulation processing of the data of n bits; and selecting plural conversion tables stored in the memory unit on the basis of the collation result.

40. The data decoding method as set forth in claim 39, wherein the method further comprises the steps of extracting data for decoding cryptogram implemented to the data ofn bits on the basis of the collation result; and decoding cryptogram of the demodulated data by using the extracted data for decoding cryptogram.

41. The data decoding method as set forth in claim 39, wherein the method comprises the steps of selecting either one of plural conversion tables stored in the memory unit in accordance with a predetermined rule when the contents data of n bits is demodulated; and selecting the conversion table on the basis of the collation result when key data is demodulated.

42. The data decoding method as set forth in claim 39, wherein the method comprises the steps of first delivering a select control signal for selecting the conversion table on the basis of the collation result in order to demodulate the enciphered key data; and demodulating the enciphered key data.

43. The data decoding method as set forth in claim 42, wherein the method further comprises the steps of extracting data for decoding cryptogram of the enciphered key data on the basis of the collation result; and decoding cryptogram of the demodulated enciphered key data by using the extracted data for decoding cryptogram.

44. The data decoding method as set forth in claim 43, wherein the method comprises the step of decoding cryptogram of the demodulated enciphered contents data by using the decoded key data.

45. The data decoding method as set forth in claim 38, wherein demodulation processing in the method is carried out on the basis of 8-16 modulation system where m is 8 and n is 16.
